# EUROPEAN PATENT APPLICATION

(11) **EP 1 511 093 A2**
(43) Date of publication of application: **02.03.2005**
(21) Application number: 04018468.1
(22) Date of filing: 04.08.2004
(51) Int. Cl.: H01L 51/20

(54) **EL device**

(30) Priority: 01.09.2003 JP 2003309229
(71) Applicant: Kabushiki Kaisha Toyota Jidoshokki, Kariya-shi, Aichi-ken (JP)
(72) Inventor: Kato, Yoshifumi, Kariya-shi Aichi-ken (JP); Ito, Hironori, Kariya-shi Aichi-ken (JP)
(74) Representative: Leson, Thomas Johannes Alois, Dipl.-Ing.

(57) **Abstract**

A dam member is formed around a light emitting region of an El element so as to surround the entire outer periphery of the light emitting region. The dam member is formed on an interface between a glass substrate and a sealing layer in a portion where neither a first electrode extraction portion of an anode nor a second electrode extraction portion of a cathode are formed, an interface between the sealing layer and the first electrode extraction portion in a portion where the first electrode extraction portion is formed, and an interface between the second electrode extraction portion and the glass substrate in a portion where the second electrode extraction portion is formed. Even if moisture or gas intrudes into those interfaces, the dam member absorbs the moisture or gas and prevents further intrusion beyond the dam member.

## Description

### BACKGROUND OF THE INVENTION

### Field of the Invention:

The present invention relates to an electroluminescence (EL) device, in particular, an improvement in moisture and water proof.

### Description of the Related Art:

Up to now, EL devices, for example, inorganic or organic EL devices have been widely put into practical use as displays for thin, lightweight portable devices or illuminators on account of being self-luminous and capable of providing a high-luminance screen. The EL device is structured so that an EL element is formed on a substrate, the EL element having a pair of electrode layers, at least one of which constitutes a transmissive electrode, and an electroluminescence layer interposed between the electrode layers.

As regards this type of EL device, there is a possibility that the electroluminescence layer of the EL element is damaged by intrusion of moisture or gas to deteriorate an image quality or shorten a lifetime. To cope with this, it has been proposed to cover the surface of the EL element with a sealing layer for avoiding the intrusion of moisture or gas from the outside.

For example, JP 2002-222691 A discloses a technique for applying polysilazane to a surface of an EL element to form a silica layer or silica-based layer as a sealing layer.

However, in the case of covering the EL element surface with a sealing layer as mentioned above, there is a possibility that, regardless of how excellent the shielding property of the layer itself may be, the intrusion of the moisture or gas from the outside is allowed through any interface between the sealing layer and the substrate to damage the electroluminescence layer.

### SUMMARY OF THE INVENTION

The present invention has been made with a view of solving the aforementioned problems inherent in the conventional techniques and therefore has an obj ect to provide an EL device capable of avoiding any deterioration of an electroluminescence layer caused by intrusion of moisture or gas.

An EL device according to the present invention includes:
a substrate;
an EL element formed on a surface of the substrate and including at least a first electrode layer, an electroluminescence layer and a second electrode layer sequentially stacked on the substrate;
a sealing layer covering a surface of the EL element; and
a dam member arranged between the sealing layer and the substrate and adapted to avoid a situation where at least one of a liquid and a gas intrudes from outside into any interface between the sealing layer and the substrate to reach the electroluminescence layer.

The dam member blocks liquid and gas that intrudes from the outside into the interface between the sealing layer and the substrate, whereby the liquid and the gas are kept from reaching the electroluminescence layer.

Here, the term "electroluminescence layer" generically represents layers contributing to light emission, which are formed between the first and second electrode layers.

### BRIEF DESCRIPTION OF THE DRAWINGS

Fig. 1 is a plan view showing a structure of an EL device according to a first embodiment of the present invention;
Figs. 2A to 2C are sectional views taken along the line A-A, the line B-B, and the line C-C, respectively, of Fig. 1, each of which shows the EL device according to the first embodiment of the present invention;
Figs. 3A to 3C are plan views each showing a manufacturing method for the EL device according to the first embodiment of the present invention in the step order;
Figs. 4A to 4C are sectional views corresponding to ones taken along the line A-A, the line B-B, and the line C-C, respectively, of Fig. 1, each of which shows an EL device according to a second embodiment of the present invention;
Figs. 5A to 5C are sectional views corresponding to ones taken along the line A-A, the line B-B, and the line C-C, respectively, of Fig. 1, each of which shows an EL device according to a third embodiment of the present invention; and
Fig. 6 is a plan view showing a mask used for production of modified examples of the first to third embodiments of the present invention.

### DETAILED DESCRIPTION OF THE PREFERRED EMBODIMENTS

Hereinafter, preferred embodiments of the present invention will be described with reference to the accompanying drawings.

### First Embodiment:

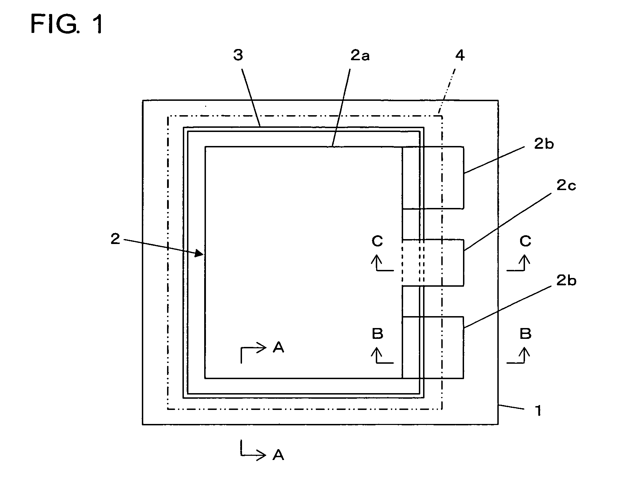

Fig. 1 is a plan view showing an EL device according to a first embodiment of the present invention. An EL element 2 is formed on a transparent glass substrate 1. The EL element 2 has a light emitting region 2a of a substantially rectangular shape. Around the light emitting region 2a, a dam member 3 is formed entirely surrounding an outer periphery of the light emitting region 2a. A sealing layer 4 covers over the entire surfaces of the light emitting region 2a of the EL element 2 and the dam member 3. The EL element 2 further has a first electrode extraction portion 2b and a second electrode extraction portion 2c, both of which extend outwards from the light emitting region 2a.

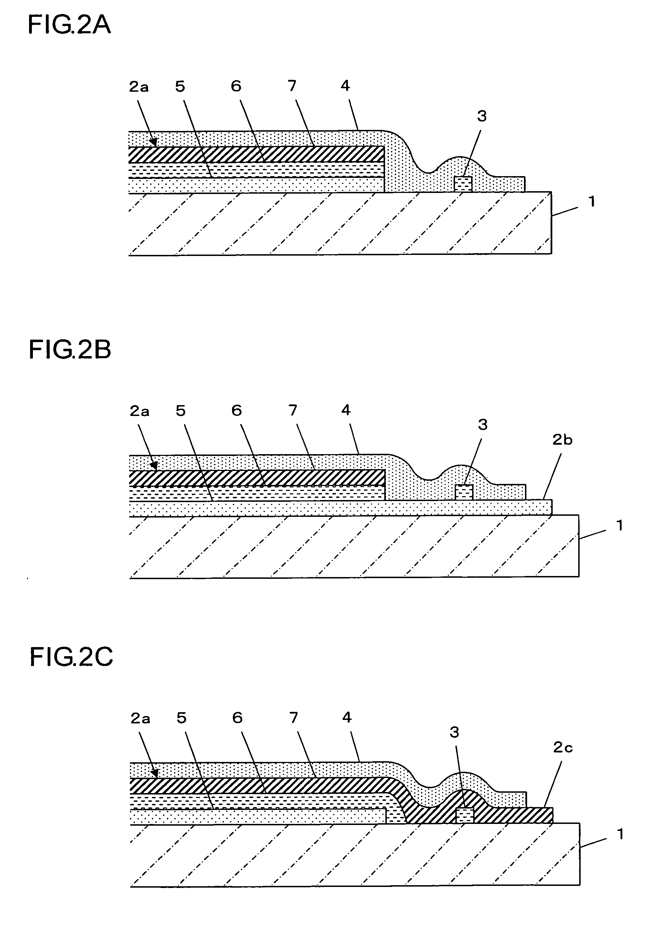

Figs. 2A, 2B and 2C are sectional views taken along the line A-A, the line B-B, and the line C-C, respectively, of Fig. 1.

As shown in Figs. 2A to 2C, the EL element 2 includes an anode 5 formed on a surface of the glass substrate 1 as a first electrode layer, an organic electroluminescence layer 6 formed on the anode 5, and a cathode 7 formed on the organic electroluminescence layer 6 as a second electrode layer. Note that, a laminate of the anode 5, the organic electroluminescence layer 6, and the cathode 7 forms the light emitting region 2a of the EL element 2 in Fig. 1.

Here, as shown in Fig. 2A, in a portion where neither the first electrode extraction portion 2b nor the second electrode extraction portion 2c are formed, the sealing layer 4 lies on the surface of the glass substrate 1 situated outside the light emitting region 2a. The dam member 3 is formed on an interface between the sealing layer 4 and the glass substrate 1.

As shown in Fig. 2B, the first electrode extraction portion 2b extends from the anode 5 to be arranged on the surface of the glass substrate 1 situated outside the light emitting region 2a. Also, the sealing layer 4 lies on the surface of the first electrode extraction portion 2b, and the dam member 3 is formed on an interface between the first electrode extraction portion 2b and the sealing layer 4.

Further, as shown in Fig. 2C, the second electrode extraction portion 2c extends from the cathode 7 to be arranged on the surface of the glass substrate 1 situated outside the light emitting region 2a. The dam member 3 is formed on an interface between the second electrode extraction portion 2c and the glass substrate 1. Note that the sealing layer 4 lies on the surface of the second electrode extraction portion 2c. Also, the anode 5 and the cathode 7 are insulated from each other by the organic electroluminescence layer 6 covering an edge portion of the anode 5.

Here, the dam member 3 is formed of the same material as that for the organic electroluminescence layer 6 and has high absorption property for moisture and/or gas intruding through the interface from the outside. In addition, it is preferable that the dam member 3 is formed about 50 nm to 500 nm in height and is located at a predetermined distance apart from the outer periphery of the light emitting region 2a.

Also, the glass substrate 1 may be formed of a material transmissive or semi-transmissive for visible light. In addition to glass, a resin meeting such a condition may be used.

The anode 5 of the EL element 2 has only to be transmissive or semi-transmissive for at least visible light while functioning as an electrode. For example, ITO is used as a material therefor. The organic electroluminescence layer 6 is made of a material containing at least any known organic light emitting substance such as Alq₃ or DCM. One or more layers such as an electron transporting layer and a hole transporting layer may be formed between the electrodes as appropriate, the layers being used in conventional organic EL devices. The respective layers are appropriately formed of any known material. The cathode 7 has only to function as an electrode as well as exhibit a reflectivity against at least visible light. For example, Al, Cr, Mo, an Al alloy, an Al/Mo laminate, or the like can be used therefor. Each layer may be formed by any known thin film formation method, e.g., vacuum deposition.

Further, the sealing layer 4 can be an oxide layer, nitride layer, or the like and be formed through either a wet process or a dry process. Further, plural layers may constitute the sealing layer 4.

In the EL device thus structured, a light emitting surface corresponds to the principle surface of the glass substrate 1 opposite to the surface having the EL element 2 formed thereon. To elaborate, the light emitted from the organic electroluminescence layer 6 directly enters the anode 5 or indirectly enters there after being reflected by the cathode 7, and then, passes through the glass substrate 1 and emits therefrom.

Next, an operation of the EL device according to the first embodiment will be described. As shown in Fig. 2A, in a portion where neither the first electrode extraction portion 2b of the anode 5 nor the second electrode extraction portion 2c of the cathode 7 are formed, the dam member 3 is formed on the interface between the glass substrate 1 and the sealing layer 4. Hence, even if the moisture or gas intrudes from the outside into the interface between the glass substrate 1 and the sealing layer 4, the dam member 3 absorbs the moisture or gas to block further intrusion thereof beyond the dam member 3.

Similarly, as shown in Fig. 2B, in a portion where the first electrode extraction portion 2b is formed, the dam member 3 is formed on the interface between the sealing layer 4 and the first electrode extraction portion 2b. Thus, even if the moisture or gas intrudes from the outside into the interface between the sealing layer 4 and the first electrode extraction portion 2b, the dam member 3 absorbs the moisture or gas to block further intrusion thereof beyond the dam member 3.

Furthermore, as shown in Fig. 2C, in a portion where the second electrode extraction portion 2c is formed, the dam member 3 is formed on the interface between the second electrode extraction portion 2c and the glass substrate 1. Thus, even if the moisture or gas intrudes from the outside into the interface between the second electrode extraction portion 2c and the glass substrate 1, the dam member 3 absorbs the moisture or gas to block further intrusion thereof beyond the dam member 3.

To elaborate, the dam member 3 is formed so as to surround the entire outer periphery of the organic electroluminescence layer 6 of the EL element 2 and thus absorbs the moisture or gas intruding from the outside into any interface between the sealing layer 4 and the glass substrate 1. The provision of the dam member keeps the moisture or gas from reaching the organic electroluminescence layer 6, therefore prevents the organic electroluminescence layer 6 from being damaged.

Also, as shown in Fig. 2C, the dam member 3 is formed on the interface between the glass substrate 1 and the second electrode extraction portion 2c of the cathode 7. Therefore, above the dam member 3, the interface between the second electrode extraction portion 2c and the sealing layer 4 protrudes upwards in a convex shape. With this shape, even if the moisture or gas intrudes from the outside into the interface between the second electrode extraction portion 2c and the sealing layer 4, the protruding portion of the interface blocks the proceeding of the moisture or gas to hinder its intrusion beyond the portion. And, even if the moisture or gas intrudes from the outside into the interface between the second electrode extraction portion 2c and the glass substrate 1, the dammember 3 absorbs the moisture or gas to block further intrusion thereof beyond the dam member 3.

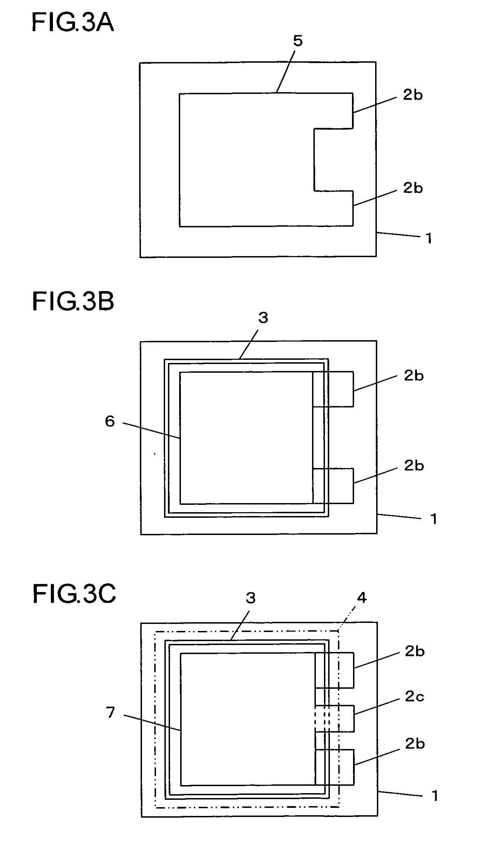

Next, a manufacturing method for the aforementioned EL device is described. As shown in Fig. 3A, the anode 5 having the first electrode extraction portion 2b is formed on the surface of the glass substrate 1.

Subsequently, as shown in Fig. 3B, two masks are used for separately forming the organic electroluminescence layer 6 and the dam member 3. More specifically, the organic electroluminescence layer 6 with a rectangular pattern is formed on the surface of the anode 5 and in addition, the dam member 3 is formed on the glass substrate 1 so as to surround the entire outer periphery of the organic electroluminescence layer 6. At this time, the dam member 3 is formed to overlap with the surface of the first electrode extraction portion 2b of the anode 5.

Further, as shown in Fig. 3C, the cathode 7 having the second electrode extraction portion 2c is formed on the surface of the organic electroluminescence layer 6. Following this, the sealing layer 4 is formed to cover the surfaces of the anode 5, the organic electroluminescence layer 6, the cathode 7, and the dam member 3. Note that the second electrode extraction portion 2c of the cathode 7 is formed to cross over a part of the dam member 3.

The EL device is manufactured in this way. Also, in the first embodiment, the dam member 3 is formed of the same material as that for the organic electroluminescence layer 6. However, the present invention is not limited thereto. The same effects as the first embodiment can be attained insofar as the dam member is made of a material capable of absorbing a liquid and/or gas.

### Second Embodiment:

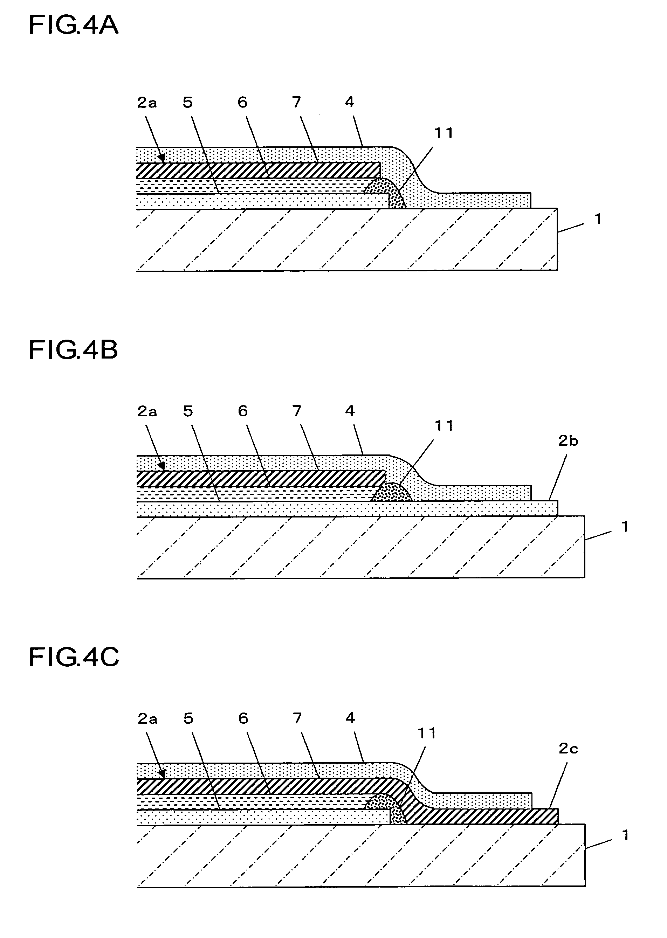

Next, referring to Figs. 4A to 4C, a description will be given of an EL device according to a second embodiment of the present invention. The EL device of the second embodiment is provided with a dam member 11 formed on the peripheral portion of the light emitting region 2a instead of the dam member 3 formed apart from the light emitting region 2a in the EL device of the first embodiment as shown in Fig. 1. Here, Figs. 4A, 4B and 4C are sectional views correspoding to ones taken along the line A-A, the line B-B, and the line C-C, respectively, of Fig. 1. Note that the dam member 11 has high absorption property for the moisture and/or gas intruding from the outside through any interface.

Even if the dam member 11 is formed at the peripheral portion of the light emitting region 2a in such a manner, the dam member 11 serves to absorb the moisture or gas intruding into the interface between the sealing layer 4 and the glass substrate 1 as shown in Fig. 4A, the interface between the first electrode extraction portion 2b of the anode 5 and the sealing layer 4 as shown in Fig. 4B, and the interface between the second electrode extraction portion 2c of the cathode 7 and the glass substrate 1 as shown in Fig. 4C. Accordingly, it is possible, as in the first embodiment, to prevent the moisture and the gas from reaching the organic electroluminescence layer 6.

Also, the dam member 11 formed of an electrically insulating material can function as an insulating film for insulating the anode 5 and the cathode 7 from each other.

### Third Embodiment:

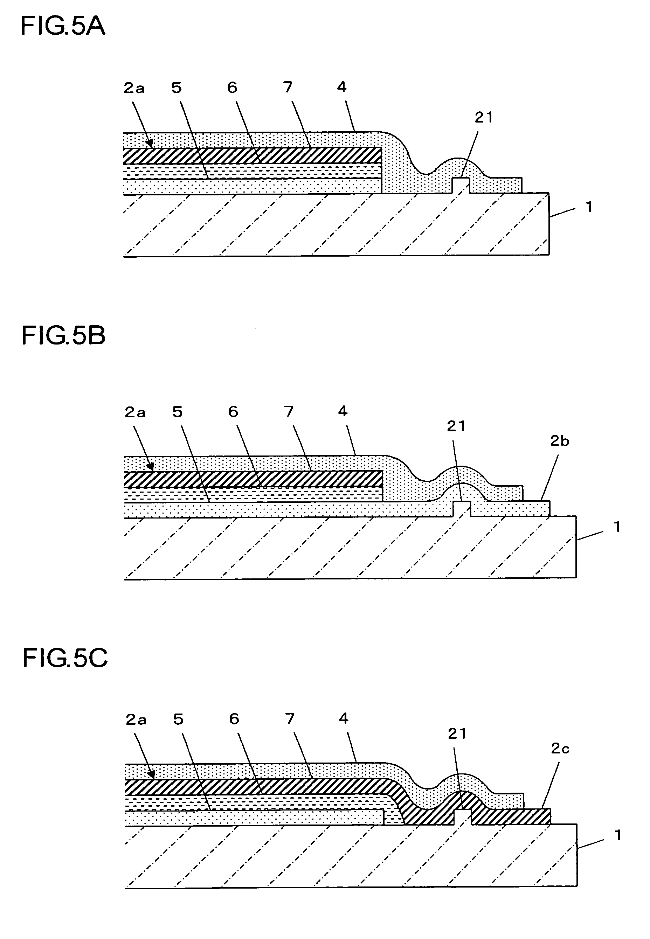

Next, referring to Figs. 5A to 5C, a description will be given of an EL device according to a third embodiment of the present invention. The EL device of the third embodiment is provided with a dam member 21 that is formed integrally with the glass substrate 1 instead of the dam member 3 in the EL device of the first embodiment as shown in Fig. 1. Here, Figs. 5A, 5B and 5C are sectional views corresponding to ones taken along the line A-A, the line B-B, and the line C-C, respectively, of Fig. 1.

The dam member 21 is formed of the same material as that for the glass substrate 1 so as to protrude upwards from the glass substrate 1. More specifically, the dam member 21 is formed to protrude at the interface between the sealing layer 4 and the glass substrate 1 as shown in Fig. 5A, the interface between the first electrode extraction portion 2b of the anode 5 and the glass substrate 1 as shown in Fig. 5B, and the interface between the second electrode extraction portion 2c of the cathode 7 and the glass substrate 1 as shown in Fig. 5C, respectively. In this manner, the dam member 21 is formed integrally with the glass substrate 1 while protruding upwards from the glass substrate 1 to block further intrusion of the moisture and the gas that intruded into those interfaces.

Also, the interface between the first electrode extraction portion 2b and the sealing layer 4 as shown in Fig. 5B and the interface between the second electrode extraction portion 2c and the sealing layer 4 as shown in Fig. 5C protrude upwards in a convex shape, above the dam member 21. Hence, even if the moisture and the gas intrude from the outside into any of those interfaces, the protruding portion of the interface hinder the proceeding of the moisture and the gas.

It is therefore possible to keep the moisture and the gas intruding from the outside from reaching the organic electroluminescence layer 6.

Note that the dam member 21 can be formed by subjecting the surface of the glass substrate 1 to glass etching or the like.

Here, in the first to third embodiments, the description has been directed to an organic EL device of a bottom emission type where the transmissive anode 5, the organic electroluminescence layer 6, and the reflective cathode 7 are sequentially stacked on the glass substrate 1 and the light emitted from the organic electroluminescence layer 6 is transmitted through the anode 5 and the glass substrate 1 to emit therefrom. The present invention, however, is not limited to this but is applicable to an organic EL device of a top emission type where a reflective electrode, an organic electroluminescence layer, and a transmissive electrode are sequentially stacked on a substrate and the light emitted from the organic electroluminescence layer is transmitted through the transmissive electrode in a direction opposite to the substrate to thereby emit therefrom. For this top emission type, a sealing layer is formed on the transmissive electrode and needs to be formed of a material transmissive or semi-transmissive for visible light.

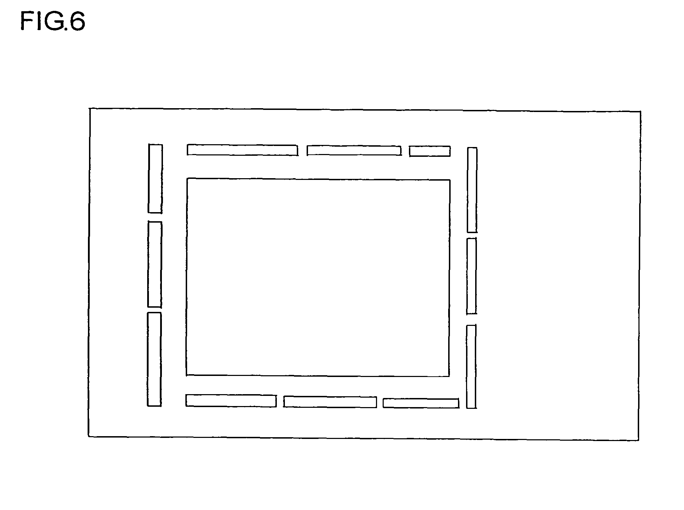

In addition, it is not always necessary that the dam member surrounds the entire outer periphery of the organic electroluminescence layer 6 like the first to third embodiments. Part of the outer periphery of the organic electroluminescence layer 6 may be unsurrounded by the dam member. In the case where the dam member is not formed in some portions as mentioned above, the dam member is formed of the same material as that for the organic electroluminescence layer 6 and a mask as shown in Fig. 6 is used, for instance, to allow simultaneous formation of the dam member and the organic electroluminescence layer 6. In such a case, the portions where the dam member is not formed are desirably set as small as possible.

When the organic electroluminescence layer 6 is constituted of plural layers, the dam member may be formed by using either all or part of the plural layers.

The description has been given regarding the organic EL device so far, but the present invention is similarly applicable to an inorganic EL device.

According to the present invention, the dam member is provided, which is arranged between the sealing layer and the substrate to thereby avoid a situation where the liquid and/or gas intrudes from the outside into any interface between the sealing layer and the substrate to reach the electroluminescence layer. Consequently, the liquid and the gas intruding into the interface keep from reaching the electroluminescence layer by the dam member, whereby it is possible to prevent any deterioration of the electroluminescence layer due to the intrusion of the liquid or gas from the outside.

A dam member is formed around a light emitting region of an El element so as to surround the entire outer periphery of the light emitting region. The dam member is formed on an interface between a glass substrate and a sealing layer in a portion where neither a first electrode extraction portion of an anode nor a second electrode extraction portion of a cathode are formed, an interface between the sealing layer and the first electrode extraction portion in a portion where the first electrode extraction portion is formed, and an interface between the second electrode extraction portion and the glass substrate in a portion where the second electrode extraction portion is formed. Even if moisture or gas intrudes into those interfaces, the dam member absorbs the moisture or gas and prevents further intrusion beyond the dam member.

## Claims

1. An EL device, comprising:
a substrate;
an EL element formed on a surface of the substrate and including at least a first electrode layer, an electroluminescence layer and a second electrode layer sequentially stacked on the substrate;
a sealing layer covering a surface of the EL element; and
a dam member arranged between the sealing layer and the substrate and adapted to avoid a situation where at least one of a liquid and a gas intrudes from outside into any interface between the sealing layer and the substrate to reach the electroluminescence layer.

2. An EL device according to claim 1, wherein the dam member is formed to surround an entire outer periphery of the electroluminescence layer.

3. An EL device according to claim 1, wherein:
the second electrode layer has an electrode extraction portion extending to outside of the electroluminescence layer on the substrate with an upper surface being covered with the sealing layer, the dam member being formed on an interface between the electrode extraction portion of the second electrode layer and the substrate.

4. An EL device according to claim 3, wherein an interface between the electrode extraction portion of the second electrode layer and the sealing layer, which is located above the dam member, protrudes upwards in a convex shape.

5. An EL device according to claim 1, wherein:
the first electrode layer has an electrode extraction portion extending to outside of the electroluminescence layer on the substrate with an upper surface being covered with the sealing layer, the dam member being formed on an interface between the electrode extraction portion of the first electrode layer and the sealing layer.

6. An EL device according to claim 1, wherein the dam member is formed of a material capable of absorbing at least one of a liquid and a gas.

7. An EL device according to claim 6, wherein the dam member is formed of the same material as that for the electroluminescence layer.

8. An EL device according to claim 1, wherein the dam member is formed of the same material as that for the substrate and is formed to protrude upwards from the substrate.

9. An EL device according to claim 1, wherein:
the first electrode layer has an electrode extraction portion extending to outside of the electroluminescence layer on the substrate with an upper surface being covered with the sealing layer, the dam member being formed on an interface between the electrode extraction portion of the first electrode layer and the substrate.

10. An EL device according to claim 9, wherein an interface between the electrode extraction portion of the first electrode layer and the sealing layer, which is located above the dam member, protrudes upwards in a convex shape.

11. An EL device according to claim 1, wherein the dam member functions as an insulating film for insulating the first electrode layer and the second electrode layer from each other.

12. An EL device according to claim 1, wherein the dam member is formed with a height of about 50 nm to 500 nm.
